# EUROPEAN PATENT APPLICATION

(11) **EP 3 848 966 A1**
(43) Date of publication of application: **14.07.2021**
(21) Application number: 20151460.1
(22) Date of filing: 13.01.2020
(51) Int. Cl.: H01L 27/146

(54) **PIXEL CELL AND METHOD FOR MANUFACTURING A PIXEL CELL**

(71) Applicant: ams Sensors Belgium BVBA, 2600 Antwerpen (BE)
(72) Inventor: Xhakoni, Adi, 5656 AE Eindhoven (NL)
(74) Representative: Epping - Hermann - Fischer

(57) **Abstract**

A pixel cell (1) comprises a first group and a second group of subpixels (11, 12). The first group of subpixels (11) is configured to detect electromagnetic radiation in a first wavelength range and the second group of subpixels (12) is configured to detect electromagnetic radiation in a second wavelength range different from the first wavelength range. Moreover, the first and the second groups of subpixels (11, 12) are arranged adjacent to each other in a lateral direction that is parallel to a main plane of extension of the pixel cell (1) such that the first group of subpixels (11) at least partially surrounds the second group of subpixels (12) in the lateral direction.

## Description

The present disclosure relates to a pixel cell for use in semiconductor image sensors and to a method for manufacturing such a pixel cell.

CMOS image sensors are used in a wide range of applications, such as for camera modules and smartphones, tablet computers, laptops etc. Some of these applications, such as photography, rely on sensitivities in the visible optical domain while other applications, such a 3D imaging and identification, require the image sensor to be sensitive in the infrared domain. Due to space constraints in state of the art devices, it is desirable to provide an image sensor that is sensitive in both the visible and in the infrared domain. To this end, each pixel cell of the image sensor comprises color pixels, each sensitive to a certain portion of the visible spectrum as well as an infrared pixel.

Pixel cells that have only color pixels typically have these arranged in a specific pattern, the so-called Bayer filter array pattern, wherein the pixel cell comprises four pixels that are arranged in a 2x2 matrix, of which two pixels are arranged opposite to each other and are sensitive to the green portion of the visible spectrum, while the other two pixels show sensitives in the blue and red domain, respectively. Implementing an additional infrared pixel in these image sensors is typically achieved by sacrificing one of the green pixels of a Bayer filter array pattern in each pixel cell. However, this leads to the fact that standard demosaicing, or debayering, algorithms that rely on a true Bayer filter array pattern cannot be performed anymore, thus resulting in a deteriorated image quality and/or to complicated computation-intensive algorithms.

In addition to the captured images in both the visible and the infrared domain having to be interpolated for the missing information due to "blind pixels" for the respective band, a further drawback of such image sensors arises from the fact that pixels for infrared light require a larger surface than those for the visible band due to the higher diffraction limit. This means either that an infrared pixel has a worse sensitivity than the color pixels or it has to be dimensioned larger than the color pixels, meaning that a combined arrangement is impossible to achieve without sacrificing resolution.

Therefore, an object to be achieved is to provide an improved concept for a pixel cell, which is capable of sensing electromagnetic radiation at two different wavelength ranges and which overcomes at least one of the problems of existing pixel cells.

This object is achieved with the subject-matter of the independent claims. Embodiments and developments of the improved concept are defined as the dependent claims.

The improved concept is based on the idea of arranging the pixels for a first wavelength range, e.g. a range in the visible domain, of a pixel cell in a structure that at least partially surrounds a center pixel for a second wavelength range, e.g. a range in the infrared domain. A desirable filter array pattern for the first wavelength range, e.g. a Bayer filter arrangement for the visible domain, can be realized by a ring-like structure that comprises the required pixels for the first wavelength range and surrounds a pixel for the second wavelength range. As a result, pixels for the second wavelength range with a large enough surface for suitable sensitivity are provided while maintaining a desired filter array pattern of the pixels for the first wavelength range for supporting standard demosaicing and enabling accurate color reconstruction algorithms, for instance.

A pixel cell according to the improved concept comprises a first group and a second group of subpixels. The first group of subpixels is configured to detect electromagnetic radiation in a first wavelength range, and the second group of subpixels is configured to detect electromagnetic radiation in a second wavelength range that is different from the first wavelength range. The first and the second groups of subpixels are arranged adjacent to each other in a lateral direction that is parallel to a main plane of extension of the pixel cell such that the first group of subpixels at least partially surrounds the second group of subpixels in the lateral direction.

For example, the first wavelength range comprises at least a part of the visible spectrum, and the second wavelength range comprises at least a part of the infrared spectrum, in particular a wavelength range in the near-infrared regime, e.g. around 940 or 850 nm. Analogously, embodiments where the first wavelength range comprises at least a part of the infrared spectrum and where the second wavelength range comprises at least a part of the visible spectrum is likewise possible.

Image sensors with sensitivity in the visible domain and comprising subpixels in each pixel cell that are sensitive in the infrared domain can be conveniently employed for both imaging in the visible, such as photography, as well as imaging in the infrared for 3D imaging and/or identification applications that use active illumination with an infrared light source, for instance.

Each subpixel of a pixel cell according to the improved concept is configured to capture optical information that is incident upon the respective subpixel and to generate electrical information representative of the optical information. Especially for image sensors fabricated according to standard CMOS technologies, the working principle of the subpixels is the conversion of optical intensity into a photocurrent using a photodiode. Silicon-based photodiodes are a common choice in this connection, as these diodes are sensitive over a broad wavelength range between 190 nm and 1100 nm and therefore cover the relevant part of the electromagnetic spectrum in both the visible and in the infrared domain. In addition, due to the large bandgap of silicon, silicon-based photodiodes show a superior noise performance compared to other photodiodes, such as germanium-based photodiodes.

For readout purposes, i.e. for the transfer of charges from the photodiodes to a storage capacitor, memory element, analog-to-digital converter or the like, the first and second group of subpixels can be connected to a shared floating diffusion. Alternatively, the first and second group of subpixels can be connected to a respective first and second floating diffusion or all subpixels are connected to an individual floating diffusion.

For adjusting the sensitivity to a certain portion of the spectrum of incident electromagnetic radiation, in addition to a photodiode, each subpixel can comprise an optical filter that is arranged between a sensitive surface of the subpixel, i.e. of the photodiode, and a source of the incident electromagnetic radiation. For example, each subpixel of the first group of subpixels comprises a color filter.

The color filter for each subpixel of the first group of subpixels can be one of complementary color filters, for example according to the RGB additive color model. For instance, a red color filter is transmissive or translucent for red light but opaque for other light, particularly for green and blue light. Hence, for each of the complementary colors red, green and blue, there is at least one subpixel of the first group of subpixels that is sensitive for the respective complementary color.

Analogously, each subpixel of the second group of subpixels can comprise an infrared filter, in particular a near-infrared filter.

In order to provide a subpixel in each pixel cell that is predominantly or exclusively sensitive to infrared light of a certain wavelength range, the subpixels of the second group of subpixels can comprise an infrared filter. The wavelength range at which said infrared filter is transmissive can be dependent on the spectrum of an illuminating light source such as an infrared LED, for instance. For example, the wavelength range of transmission of the infrared filter includes light at 940 nm or at 850 nm.

According to the improved concept, the first and second groups of subpixels are arranged such that the first group of subpixels at least partially surrounds the second group of subpixels with respect to the lateral direction. This means that sensitive surfaces of all subpixels are arranged parallel and adjacent to each other facing the same direction, i.e. a direction that is perpendicular to a main plane of extension of the pixel cell. For example the combined sensitive surface of the first group of subpixels forms a first ring-like object and the sensitive surface of the second group of subpixels forms a second object that is smaller than and concentric to the first object. In other words, in some embodiments, the first group of subpixels completely surrounds the second group of subpixels. For example, the first and the second objects are of rectangular shape, in particular of square shape.

The first group of subpixels can consist of a single rectangular or square subpixel wherein a smaller rectangular or square subpixel occupies a center section of said single subpixel and comprises the second group of subpixels. Alternatively, the first group of subpixels can comprise four L-shaped subpixels that are arranged to form the ring-like structure around the second group of subpixels. The second group of subpixels can analogously consist of a single subpixel or comprise multiple subpixels that are arranged to form said rectangular or square second group of subpixels.

Alternatively, the first group of subpixels partially surrounds the second group of subpixels. For example, the second group of subpixels is surrounded in places by the first group of subpixels. The first group of subpixels can flank the second group of subpixels on two opposing sides, for instance.

In some embodiments, the first and the second groups of subpixels each form a connected space.

A connected space means that both the first and the second groups of subpixels each form a respective unit via an immediate adjacent arrangement of the subpixels of each group.

In some embodiments, the first and the second group of subpixels are comprised by a plurality of pixels, wherein each pixel comprises a subpixel of the first group of subpixels and a subpixel of the second group of subpixels.

For example, each of the pixels has a sensitive surface of rectangular shape, in particular of square shape, and a subpixel of the second group of subpixels of each of the pixels occupies a quadrant of the sensitive surface.

Such a pixel can be understood as an L-shaped subpixel of the first group of subpixels with the remaining quadrant of the rectangle or square being occupied by the subpixel of the second group of subpixels.

In some further embodiments, the pixels are arranged adjacent to each other such that the subpixels of the second group of subpixels are arranged immediately adjacent to each other.

In other words, the pixels can be arranged to form a mosaic, e.g. a 2x2 matrix, wherein the subpixels of the second group of subpixels are all arranged immediately adjacent to each other.

In some embodiments, the pixel cell further comprises a readout circuit comprising a first readout component and a second readout component. The first readout component is connected to the first group of subpixels and the second readout component is connected to the second group of subpixels.

The readout circuit can be comprised by a semiconductor body that is arranged on a surface of the subpixels that is facing away from their sensitive area, i.e. in a semiconductor layer that is arranged on the back side of a pixel layer comprising the subpixels. Besides a photodiode, the pixel layer can comprise circuit elements such as transfer gates, capacitors and a floating diffusion, for instance.

In some embodiments, color filters of the first group of subpixels are arranged in a filter array pattern for realizing a Bayer filter arrangement within the pixel cell.

The subpixels of the first group of subpixels can comprise red, green and blue color filters such that a Bayer filter array pattern is realized that encloses the subpixels of the second group of subpixels. This allows for standard demosaicing and color reconstruction algorithms. In contrast to conventional pixel cells, these embodiments do not sacrifice an entire subpixel, e.g. one of the subpixels with a green color filter, but sacrifice surface area of all pixels for accommodating an additional subpixel that is sensitive in the near-infrared domain, for instance. Furthermore, a pixel cell arrangement is provided that comprises a plurality of pixel cells according to one of the embodiments described above, wherein the pixel cells are arranged in a matrix. This means all features disclosed for the pixel cell are also disclosed for and applicable to the pixel cell arrangement and vice-versa.

For example, the pixel cell arrangement according to the improved concept comprises four pixel cells that are arranged in a 2x2 matrix.

In some embodiments, the first group of subpixels of each pixel cell comprises a color filter such that the color filters are arranged in a filter array pattern for realizing a Bayer filter arrangement within the pixel cell arrangement.

For example, the first group of subpixels of each pixel cell in the arrangement is sensitive to a certain portion of the visible domain such as the red, green or blue portion. For example, the sensitivity is achieved by employment of appropriate color filters as described above. This way, four pixel cells can be arranged in a 2x2 matrix for realizing the aforementioned Bayer filter array pattern.

Accordingly, such a matrix arrangement comprises four second groups of subpixels forming effectively four pixels that are sensitive to the infrared domain via an infrared filter, for instance.

Furthermore, an image sensor is provided that comprises a plurality of pixel cells according to one of the embodiments described above. This means all features disclosed for the pixel cell are also disclosed for and applicable to the image sensor and vice-versa.

Such an image sensor can be conveniently employed in electronic devices, such as smart phones, tablet computers and laptops, for example in a camera module that is required to operate at two different wavelength ranges. For example, the camera module is configured to operate in the visible domain for photography and/or video capturing and in the infrared domain for 3-D imaging and/or identification purposes.

The object is further solved by a method for manufacturing a pixel cell. The method comprises providing a first group of subpixels that are configured to detect electromagnetic radiation in a first wavelength range. The method further comprises providing a second group of subpixels that are configured to detect electromagnetic radiation in a second wavelength range that is different from the first wavelength range. The method further comprises arranging the first and the second groups of subpixels adjacent to each other in a lateral direction that is parallel to a main plane of extension of the pixel cell such that the first group of subpixels at least partially surrounds the second group of subpixels in the lateral direction.
Further embodiments of the method become apparent to the skilled reader from the embodiments of the pixel cell and pixel cell arrangement described above.

The following description of figures of exemplary embodiments may further illustrate and explain aspects of the improved concept. Components and parts of the pixel cell with the same structure and the same effect, respectively, appear with equivalent reference symbols. Insofar as components and parts of the pixel cell correspond to one another in terms of their function in different figures, the description thereof is not repeated for each of the following figures.

In the figures:
- Figures 1 to 3: show exemplary embodiments of a pixel cell according to the improved concept;
- Figures 4 and 5: show exemplary embodiments of a pixel used in a pixel cell according to the improved concept;
- Figures 6 and 7: show further exemplary embodiments of a pixel cell according to the improved concept; and
- Figure 8: shows an exemplary embodiment of a pixel cell arrangement according to the improved concept.

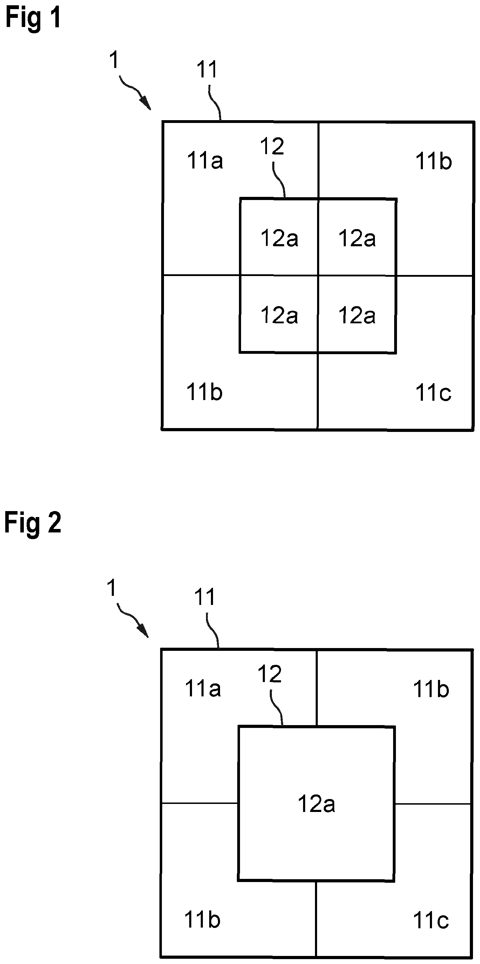

Figure 1 shows a top view of an exemplary embodiment of the pixel cell 1 according to the improved concept. The pixel cell 1 comprises a first group of subpixels 11 and a second group of subpixels 12. In this embodiment, the first group of subpixels 11 comprises a plurality of L-shaped first subpixels 11a, 11b, 11c, while the second group of subpixels 12 comprises a plurality of rectangular or square second subpixels 12a.

The first group of subpixels 11 herein forms a ring-like structure surrounding the second group of subpixels 12 in a lateral direction that is parallel to the main plane of extension of the pixel cell 1. The first subpixels 11a, 11b, 11c are sensitive to a first wavelength range. This means that the first subpixels 11a, 11b, 11c are configured to predominantly sense electromagnetic radiation in the first wavelength range. For example, the first wavelength range comprises at least a part of the visible spectrum. The first subpixels 11a, 11b, 11c can be sensitive to the same part of the first wavelength range, or alternatively 2 different portions of the first wavelength range. For example, some of the first subpixels 11a are sensitive to red light, some others of the first subpixels 11b are sensitive to green light, and the remaining of the first subpixels 11c are sensitive to blue light. For example, the sensitivity is achieved by means of appropriate color filters for each of the first subpixels 11a, 11b, 11c.

The second subpixels 12a are sensitive to a second wavelength range. This means that the second subpixels 12a are configured to predominantly sense electromagnetic radiation in the second wavelength range. For example, the second wavelength range comprises at least a part of the infrared spectrum. In particular, the second subpixels 12a are sensitive to the same part of the second wavelength range. For example, the second subpixels 12a are sensitive to near-infrared light comprising a wavelength of 940 nm or 850 nm. In other words, via an immediate adjacent arrangement, the second subpixels 12a form a connected space of equal subpixels and hence form an effective composite pixel. For example, the sensitivity is achieved by means of appropriate infrared filters for each of the second subpixels 12a.

Figure 2 shows a top view of a further exemplary embodiment of a pixel cell 1 similar to that shown in Figure 1. While the first subpixels 11a, 11b, 11c of the first group of subpixels 11 show the same segmented characteristic as in Figure 1, in this embodiment the group of second subpixels 12 consists of a single second subpixel 12a.

Providing a single second subpixel 12a can mean that less circuit elements are required for reading out a signal from the second group of subpixels 12 via a readout circuit, for instance. A further advantage of such an embodiment can be a simpler manufacturing process, for instance.

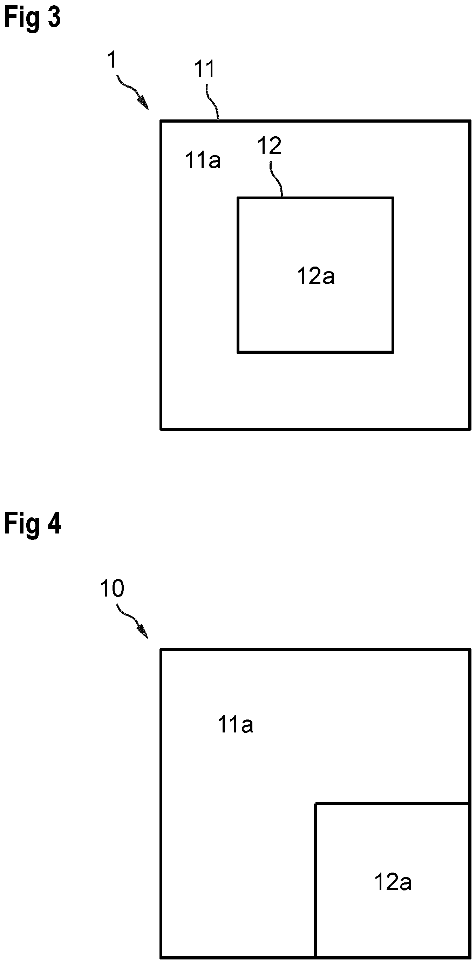

Figure 3 shows a top view of a further exemplary embodiment of a pixel cell 1 similar to that shown in Figures 1 and 2. Compared to the embodiment shown in the previous Figure 2, this embodiment is characterized by also the first group of subpixels 11 consisting of a single ring-shaped first subpixel 11a surrounding the second group of subpixels 12. The second group of subpixels 12 can consist of a single second subpixel 12a, as shown, or comprise a plurality of second subpixels 12a similar to the embodiment of Figure 1.

Analogous to before, a single first subpixel 11a can likewise mean that less circuit elements are required for reading out a signal from the first group of subpixel to 11 via a readout circuit, for instance. Also here, a further advantage of such an embodiment can be a simpler manufacturing process, for instance.

Figure 4 shows a top view of a pixel 10 used in a pixel cell 1 according to the improved concept. In this embodiment, the pixel 10 has a sensitive surface of rectangular, e.g. square, shape and is segmented into a first L-shaped subpixel 11a and a second rectangular subpixel 12a occupying the remaining quadrant of the pixel 10. It is noted at this point that different size relations and arrangements between the subpixels 11a, 12a are equally possible depending on the application of the pixel 10. However, rectangular or square shaped pixels 10 are most commonly used in state-of-the-art pixel cells and image sensors.

Each of the subpixels 11a, 12a comprises a photo diode with the shape that matches that of the respective subpixel 11a, 12a and an optical filter according to the requirement of each subpixel 11a, 12a. For example, the first subpixel 11a comprises a color filter, for example a red color filter, while the second subpixel 12a comprises an infrared filter, for example a near-infrared filter.

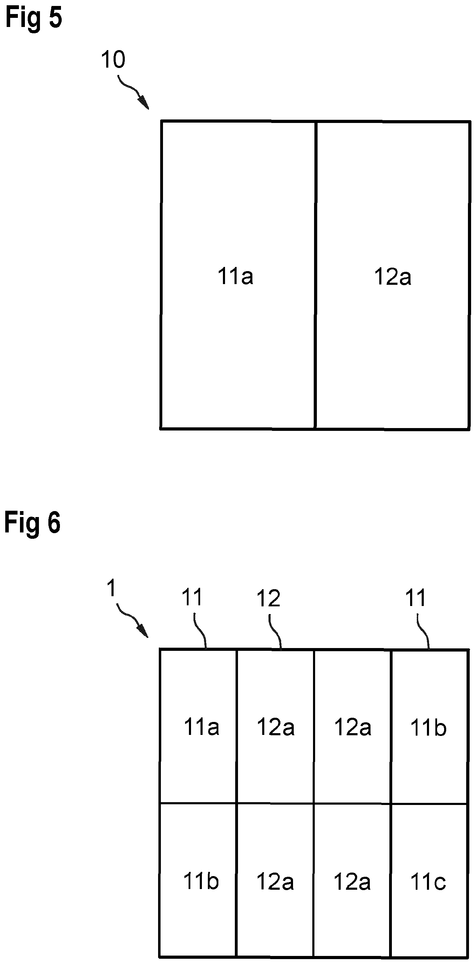

Figure 5 shows a top view of a further embodiment of a pixel 10 used in a pixel cell 1 according to the improved concept. In this embodiment, the pixel 10 likewise has a sensitive surface of rectangular, e.g. square, shape and is segmented into a first rectangular shaped subpixel 11a and a second rectangular subpixel 12a arranged adjacent to the first subpixel 11a. It is noted at this point that different size relations and arrangements between the subpixels 11a, 12a are equally possible depending on the application of the pixel 10. However, rectangular or square shaped pixels 10 are most commonly used in state-of-the-art pixel cells and image sensors.

Figure 6 shows a top view of a further exemplary embodiment of a pixel cell 1 similar to that shown in Figures 1 to 3. This embodiment comprises four pixels 10 according to the embodiment of Figure 5 arranged in a 2x2 matrix. The pixel cell 1 is characterized by the first group of subpixels 11 consisting of rectangular shaped first subpixels 11a partially surrounding the second group of subpixels 12. For example, the first group of subpixels 11 flanks the second group of subpixels 12 on two opposing sides as illustrated. The second group of subpixels 12 can comprise a plurality of second subpixels 12a, as shown, forming a composite pixel similar to the embodiment of Figure 1, or it can consist of a single second subpixel 12a.

Analogous to all embodiments, the second group of subpixels 12 can be sensitive for infrared light while the first group of subpixels can be sensitive in the visible domain. However, the vice versa case is also possible. For example, the first subpixels 11a, 11b, 11c comprise color filters in a Bayer filter pattern arrangement.

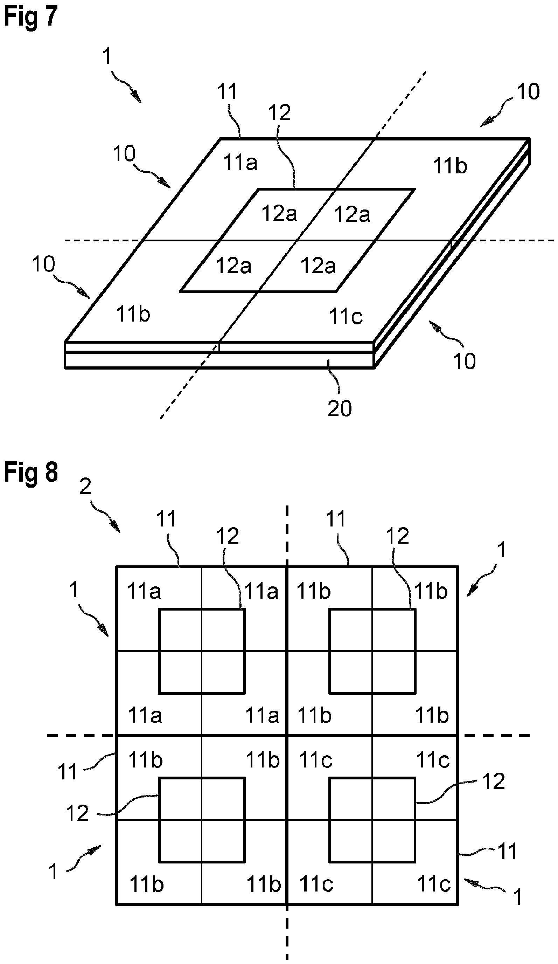

Figure 7 shows a perspective view of an exemplary embodiment of a pixel cell 1 according to the improved concept. The shown embodiment essentially corresponds to that shown in Figure 1. The dashed lines indicate that such a pixel cell can be formed as an arrangement of four pixels 10 according to Figure 4. The pixels 10 are arranged in a 2 x 2 matrix such that the second subpixels 12a are arranged immediately adjacent to each other and such that the first group of subpixels 11 completely surrounds the second group of subpixels 12 in the lateral direction as shown. Therein, the second subpixels 12a form a connected space and hence a composite pixel.

As described above, the first subpixels 11a, 11b, 11c can be characterized by color filters such that they form a Bayer filter array pattern. This means that two opposing ones of the first subpixels 11b are sensitive to green light while the remaining first subpixels 11a, 11c are sensitive to red and blue light, respectively.
In this embodiment, the pixel cell 1 further comprises a semiconductor body 20 arranged on a side of the subpixels 11a, 11b, 11c, 12a that faces away from the sensitive surface. In other words, the semiconductor body 20 is arranged on a backside of the pixel cell 1. The semiconductor body 20 can comprise a substrate and circuit elements such as active circuitry for reading out electric signals from photodiodes of the subpixels 11a, 11b, 11c, 12a.

Figure 8 shows a top view of an exemplary embodiment of a pixel cell arrangement 2. The pixel cell arrangement 2 comprises a plurality of pixel cells 1 according to one of the embodiments described above. For example, as indicated by the dashed lines, the pixel cell arrangement 2 comprises four pixel cells 1 that are arranged in a 2 x 2 matrix as a two-dimensional array as shown forming a tetra cell arrangement. The pixel cells 1 in the pixel cell arrangement 2 can be of the same embodiment or of different embodiments.

In this embodiment, the first group of subpixels 11 of each pixel cell 1 is sensitive to the same wavelength range of incident electromagnetic radiation. In other words, all first subpixels 11a, 11b, 11c of each pixel cell 1 comprises the same color filter. The color filters are chosen such that the pixel cells 1 realize the Bayer filter array pattern for the pixel cell arrangement 2. In other words, the first group of subpixels 11 of two opposing pixels cells 1 are sensitive to green light, i.e. comprise a green color filter, while the first group of subpixels 11 of the remaining pixel cells 1 are sensitive to red and green light, respectively. Such an arrangement can also be referred to as a quad Bayer arrangement that has infrared capabilities.

The embodiments of the pixel cell 1, the pixel 10 and the pixel cell arrangement 2 shown in the figures represent exemplary embodiments, therefore they do not constitute a complete list of all embodiments according to the improved concept. Actual pixel cells, pixels and pixel cell arrangements may vary from the embodiments shown in terms of additional components, shape and configuration, for instance. In particular, features shown in the various figures may be combined with each other and hence form additional embodiments according to the improved concept.

### Reference symbols

- 1: pixel cell
- 2: pixel cell arrangement
- 10: pixel
- 11: first group of subpixels
- 12: second group of subpixels
- 11a, 11b, 11c: first subpixels
- 12a: second subpixels
- 20: semiconductor body

## Claims

1. A pixel cell (1) comprising a first group and a second group of subpixels (11, 12), wherein
- the first group of subpixels (11) is configured to detect electromagnetic radiation in a first wavelength range,
- the second group of subpixels (12) is configured to detect electromagnetic radiation in a second wavelength range different from the first wavelength range, and
- the first and the second groups of subpixels (11, 12) are arranged adjacent to each other in a lateral direction that is parallel to a main plane of extension of the pixel cell (1) such that the first group of subpixels (11) at least partially surrounds the second group of subpixels (12) in the lateral direction.

2. The pixel cell (1) according to claim 1, wherein the first and the second groups of subpixels (11, 12) each form a connected space.

3. The pixel cell (1) according to claim 1 or 2, wherein the first and the second group of subpixels (11, 12) are comprised by a plurality of pixels (10), each pixel (10) comprising a subpixel (11a, 11b, 11c) of the first group of subpixels (11) and a subpixel (12a) of the second group of subpixels (12).

4. The pixel cell (1) according to claim 3, wherein
- each of the pixels (10) has a sensitive surface of rectangular, in particular of square, shape; and
- a subpixel (12a) of the second group of subpixels (12) of each of the pixels (10) occupies a quadrant of the sensitive surface.

5. The pixel cell (1) according to claim 3 or 4, wherein the pixels (10) are arranged adjacent to each other such that the subpixels (12a) of the second group of subpixels (12) are arranged immediately adjacent to each other.

6. The pixel cell (1) according to one of claims 1 to 5, wherein each subpixel (12a) of the second group of subpixels (12) comprises an infrared filter (IR), in particular a near-infrared filter.

7. The pixel cell (1) according to one of claims 1 to 6, wherein
- the first wavelength range comprises at least a part of the visible spectrum; and
- the second wavelength range comprises at least a part of the infrared spectrum, in particular a wavelength range around 940 nm or around 850 nm.

8. The pixel cell (1) according to one of claims 1 to 7, further comprising a readout circuit comprising a first readout component and a second readout component, wherein the first readout component is connected to the first group of subpixels (11) and the second readout component is connected to the second group of subpixels (12).

9. The pixel cell (1) according to one of claims 1 to 8, wherein each subpixel (11a, 11b, 11c) of the first group of subpixels (11) comprises a color filter (R, G, B).

10. The pixel cell (1) according to claim 9, wherein the color filters (R, G, B) of the first group of subpixels (11) are arranged in a filter array pattern for realizing a Bayer filter arrangement within the pixel cell (1).

11. A pixel cell arrangement (2) comprising a plurality of pixel cells (1) according to one of claims 1 to 9 that are arranged in a matrix.

12. The pixel cell arrangement (2) according to claim 11, comprising four pixel cells (1) arranged in a 2x2 matrix.

13. The pixel cell arrangement (2) according to claim 12, wherein the first group of subpixels (11) of each pixel cell (1) comprises a color filter (R, G, B) such that the color filters are arranged in a filter array pattern for realizing a Bayer filter arrangement within the pixel cell arrangement (2) .

14. An image sensor comprising a plurality of pixel cells (1) according to one of claims 1 to 10.

15. A method for manufacturing a pixel cell (1), the method comprising
- providing a first group of subpixels (11) configured to detect electromagnetic radiation in a first wavelength range;
- providing a second group of subpixels (12) configured to detect electromagnetic radiation in a second wavelength range different from the first wavelength range; and
- arranging the first and the second groups of subpixels (11, 12) adjacent to each other in a lateral direction that is parallel to a main plane of extension of the pixel cell (1) such that the first group of subpixels (11) at least partially surrounds the second group of subpixels (12) in the lateral direction.
